(19) Europäisches Patentamt

European Patent Office

Office européen des brevets

(11) **EP 0 864 873 B1**

(12) **EUROPÄISCHE PATENTSCHRIFT**

(45) Veröffentlichungstag und Bekanntmachung des Hinweises auf die Patenterteilung:
**19.11.2003 Patentblatt 2003/47**

(51) Int Cl.$^7$: **G01R 27/20**

(21) Anmeldenummer: **97104191.8**

(22) Anmeldetag: **12.03.1997**

(54) **Verfahren zur Ermittlung des Erdungsableitwiderstandes und dafür eingerichtetes Installationsnetz**

Procedure for determining the grounding resistance and house wiring adapted for same

Procédé pour déterminer la résistance de terre et réseau électrique adapté

(84) Benannte Vertragsstaaten:
**AT BE CH DE ES FR GB IT LI NL SE**

(43) Veröffentlichungstag der Anmeldung:
**16.09.1998 Patentblatt 1998/38**

(73) Patentinhaber: **SIEMENS AKTIENGESELLSCHAFT**
**80333 München (DE)**

(72) Erfinder:
• **Solleder, Reinhard, Dipl.-Ing.(FH)**
**93138 Hainsacker (DE)**

• **Schmidt, Reinhard, Dipl.-Ing.**
**93051 Regensburg (DE)**

(56) Entgegenhaltungen:
**EP-A- 0 570 654          WO-A-95/32434**

• **IEEE TRANSACTIONS ON INDUSTRY APPLICATIONS, Bd. IA-17, Nr. 6, November 1981, NEW YORK US, Seiten 587-596, XP002038528 BRINKS ET AL.: "SYSTEM GROUNDING, PROTECTION AND DETECTION FOR CEMENT PLANTS"**

EP 0 864 873 B1

**Beschreibung**

Die Erfindung bezieht sich zunächst auf ein Verfahren zur Ermittlung des Erdungsableitungwiderstandes bei einem Installationsnetz mit Neutralleiter, Erdungssystem und Potentialausgleichsschiene, die über einen Erdungsleiter bei einem Erdungsableitwiderstand geerdet ist. Der Erdungsableitwiderstand eines Erdungssystems von elektrischen Anlagen ist für die Schutzmaßnahmen, wie sie in den Errichtungsbestimmungen vorgesehen sind, von tragender Bedeutung. Derartige Schutzmaßnahmen sehen beispielsweise die Fehlerstromschutzschaltung als Personen- und Brandschutz vor. Der Erdungsableitwiderstand ist auch wesentlich für den Überspannungsschutz und für Schirmmaßnahmen unter dem Blickwinkel der elektromagnetischen Verträglichkeit.

Der Erdungsableitwiderstand kann in bestehenden Anlagen herkömmlich dadurch bestimmt werden, daß bestimmte Leiter aufgetrennt werden und daß besondere Messungen vorgenommen werden. In bestehenden Anlagen ist das in der Regel störend und aufwendig.

Patentschrift EP 570 654 offenbart die Erfassung eines Erdungswiderstandes, wobei der Erdstrom bie Anlegung einer geeigneten Spannung gemessen wird. Patentschrift WO 95/32434 offenbart die Erfassung eines Erdungswiderstandes in einer TT Netz wobei Strom beaufschlagt und Spannung gemessen wird.

Der Erfindung liegt die Aufgabe zugrunde, eine ständige Überwachung des Erdungsableitwiderstandes mit einfachen Maßnahmen bei unbeeinträchtigter Anlage zu ermöglichen.

Die Lösung der geschilderten Aufgabe erfolgt nach der Erfindung durch ein Verfahren nach Patentanspruch 1. Die Lösung erfolgt auch durch ein dafür eingerichtetes Installationsnetz nach Anspruch 4.

Die Potentialausgleichsschiene wird von einem Prüfstromgeber beaufschlagt und der Erdungsableiter der Potentialausgleichsschiene durch einen Strommesser überwacht. Der Strom wird, als Zweitstrom genannt, erfaßt. Ein Potential, zweites Potential genannt, wird an der Potentialausgleichsschiene erfaßt. Weiter wird entweder ein erstes Potential am Neutralleiter erfaßt, wobei vom Neutralleiter ein Erdungsleiter bei einem bekannten Erdungswiderstand des die Anlage versorgenden Netzes, Rev, zur Erde geführt ist. Der Erdungsableitwiderstand, Rea, am Erdungsleiter der Potentialausgleichsschiene läßt sich dann nach dem Algorithmus ermitteln

$$Rea = \frac{P2 - P1}{Ie2} - Rev.$$

Oder es wird weiter ein erstes Potential, P1', am erdabgewandten Ende einer Hilfserde, Reh, erfaßt sowie der Strom durch diese Hilfserde als sogenannter Drittstrom, Ie3. Der Erdungsableitwiderstand, Rea, am Erdungsleiter der Potentialausgleichsschiene läßt sich dann nach dem Algorithmus ermitteln

$$Rea = \frac{P2 - P1'}{Ie2} - Reh \frac{Ie3}{Ie2}.$$

Der Prüfstromgeber kann ein Oszillator sein oder eine Gleichstromquelle. Bei einer Gleichstromquelle entfällt ein über sogenannte Koppelkapazitäten abfließender Strom, hier erster Strom genannt.

Die erste Verfahrensalternative nach Anspruch 1 arbeitet ohne Hilfserde und läßt sich in TT- und TN-Netzen anwenden. Die zweite Verfahrensalternative mit Hilfserde kann darüber hinaus auch in IT-Netzen eingesetzt werden.

Bei den Netzformen bezeichnet der erste Buchstabe die Erdungsverhältnisse der Stromquelle:

T   direkte Erdung eines Netzpunktes,
I   Isolierung aller aktiven Teile von Erde oder Erdung eines Nutzpunktes über eine Impedanz.

Der zweite Buchstabe bedeutet die Erdungsverhältnisse von Körpern in der elektrischen Anlage:

T   Körper direkt geerdet, unabhängig von der Erdung der Stromquelle,
N   Körper direkt mit dem Betriebserder verbunden.

Wenn als Prüfstromgeber ein Oszillator mit höherer Frequenz als der Netzfrequenz eingesetzt wird, erzielt man unter dem Blickwinkel der Meßgenauigkeit und Störunempfindlichkeit besonders günstige Verhältnisse. Die Potentialabgriffe P1 und P2 sind vorteilhafterweise hochohmig, vorzugsweise in der Größenordnung von 1 Megohm oder darüber, ausgeführt. Wenn der Drittstrom, Ie3, bei höherer Frequenz eingesetzt wird, können die Meßwerte als Signalpegel aus dem höherfrequenten Prüfstrom ausgefiltert werden.

Bei einem Installationsnetz mit Neutralleiter, Erdungssystem und Potentialausgleichsschiene, die über einen Erdungsleiter bei einem Erdungsableitwiderstand geerdet ist, kann man folgende Vorkehrungen treffen:

An der Potentialausgleichsschiene ist ein Prüfstromgeber, insbesondere ein Oszillator angeschlossen.
Der Erdungsleiter der Potentialausgleichsschiene ist durch einen Strommesser überwacht, wobei der gemessene Strom hier als Zweitstrom, Ie2, bezeichnet ist.
Eine Potentialmeßeinrichtung für ein Potential, hier zweites Potential, P2, genannt, ist der Potentialausgleichsschiene zugeordnet.

-   Entweder ist weiter eine Potentialmeßeinrichtung dem Neutralleiter zur Erfassung des ersten Potentials, P1, zugeordnet, wobei vom Neutralleiter ein Erdungsleiter bei einem bekannten Erdungswiderstand des die Anlage versorgenden Netzes, Rev, zur Erde geführt ist und der Erdungsableitwiderstand, Rea, am Erdungsleiter der Potentialausgleichsschiene ermittelbar ist, gemäß dem Algorithmus

$$Rea = \frac{P2 - P1}{Ie2} - Rev.$$

- Oder es ist weiter eine Potentialmeßeinrichtung dem erdabgewandten Ende einer Hilfserde, Reh, zugeordnet. Hierdurch kann ein erstes Potential, P1', gemessen werden. Eine Strommeßeinrichtung ist der Hilfserde zugeordnet, wodurch der hindurchfließende Strom, hier Drittstrom, Ie3, genannt, gemessen werden. Der Erdungsableitwiderstand, Rea, am Erdungsleiter der Potentialausgleichsschiene ist dann durch eine Einrichtung ermittelbar, die den Algorythmus abarbeitet

$$Rea = \frac{P2 - P1'}{Ie2} - Reh \frac{Ie3}{Ie2}.$$

Ein derartiges Installationsnetz erlaubt, auf einfache Weise nach dem erfindungsgemäßen Verfahren zu arbeiten.

Es ist vorteilhaft, wenn zumindest ein Teil der Erfassungen in einer Meß- und Steuereinheit erfolgt. Die Meß- und Steuereinheit kann an einem Melde- und Steuerbus angeschlossen sein.

Die Erfindung soll nun anhand von in der Zeichnung grob schematisch wiedergegebenen Ausführungsbeispielen näher erläutert werden:

In FIG 1 ist ein Installationsnetz veranschaulicht, das unter Einbeziehung eines Erdungswiderstandes des die Anlage versorgenden Netzes, Rev, ohne Hilfserde nach der ersten Verfahrensalternative arbeitet.

In FIG 2 ist ein Installationsnetz wiedergegeben, das nach der zweiten Verfahrensvariante arbeitet, also mit einer Hilfserde, Reh. Hierbei ist ein Erdungswiderstand des die Anlage versorgenden Netzes, Rev, nicht in die Ermittlung des Erdungsableitwiderstandes, Rea, einbezogen.

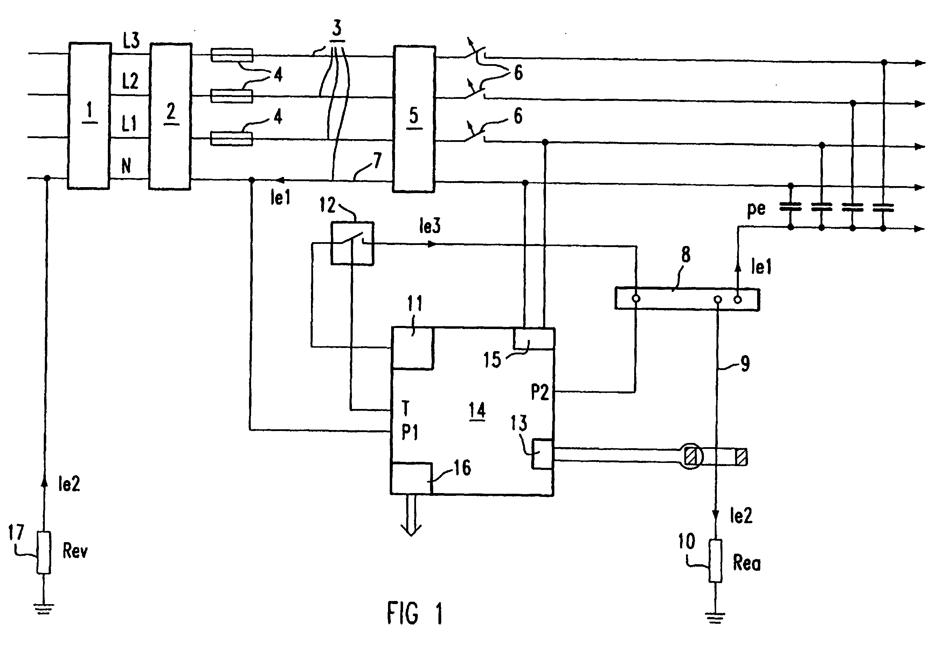

Das Installationsnetz im Ausführungsbeispiel nach FIG 1 weist einen Hausanschluß 1, einen Zähler 2 und Leiter 3 auf, die durch Kurzschlußvorsicherungen 4 abgesichert sind. Die Leiter 3 sind weiter durch eine Fehlerstromschutzeinrichtung 5 und durch Leitungsschutzschalter 6 abgesichert. Das Installationsnetz weist einen Neutralleiter 7 und ein Erdungssystem mit Potentialausgleichsschiene 8 auf. Die Potentialausgleichsschiene 8 ist über einen Erdungsleiter 9 bei einem Erdungsableitwiderstand 10, Rea, geerdet. An der Potentialausgleichsschiene 8 ist ein Prüfstromgeber 11 angeschlossen. Der Prüfstromgeber kann insbesondere als Oszillator ausgebildet sein. Der Prüfstrom vom Prüfstromgeber 11 kann über eine Schalteinrichtung 12 bei Signal von einem Taktgeber T auf die Potentialausgleichsschiene 8 gegeben werden. Das Potential auf der Potentialausgleichsschiene 8 wird durch eine Potentialmeßeinrichtung überwacht, die das zweite Potential, P2, erfaßt. Eine weitere Potentialmeßeinrichtung ist dem Neutralleiter 7 zur Erfassung eines ersten Potentials, P1, zugeordnet. Der Neutralleiter ist über einen Erdungsleiter bei einem bekannten Erdungswiderstand des die Anlage versorgenden Netzes, Rev, zur Erde verbunden. Ein Strommesser 13 mißt den durch den Erdungsleiter 9 fließenden Zweitstrom, Ie2. Der Erdungsableitwiderstand 10, Rea, ist nach dem Algorythmus ermittelbar

$$Rea = \frac{P2 - P1}{Ie2} - Rev.$$

Im Ausführungsbeispiel werden die Ströme und Potentiale in einer Meß- und Steuereinheit 14 erfaßt. Die Meß- und Steuereinheit 14 ist mit ihrem Netzteil 15 am Leitungsnetz angeschlossen. Über einen Busausgang 16 kann ein Melde- und Steuerbus angeschlossen werden. Für die Ermittlung des Erdungsableitwiderstandes 10, Rea, ist ein vorhandener und der Größe nach bekannter Erdungswiderstand 17 des die Anlage versorgenden Netzes, Rev, einbezogen.

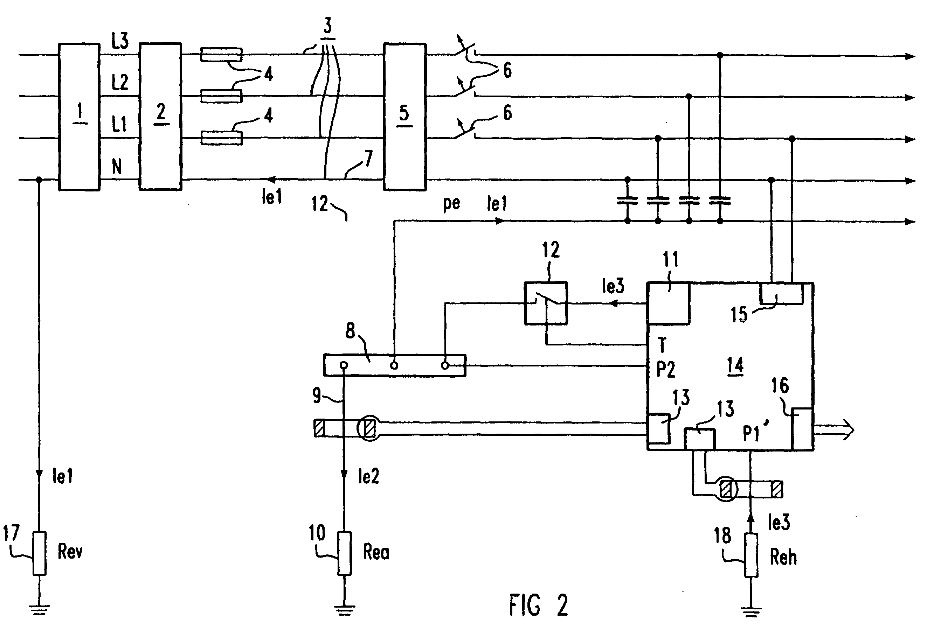

Im Ausführungsbeispiel nach FIG 2 wird wieder mit einem zweiten Potential, P2, das der Potentialausgleichsschiene zugeordnet ist, gearbeitet. Ein erstes Potential, P1', wird jedoch von einem Erdungsleiter durch eine Hilfserde 18, Reh, bestimmt. Es wird weiter der Strom, Ie3, durch diese Hilfserde 18 gemessen oder errechnet. Der Strom durch die Hilfserde 18, Reh, wird hier als Drittstrom, Ie3, bezeichnet. Der Erdungsableitwiderstand 10, Rea, kann dann nach dem Algorythmus ermittelt werden:

$$Rea = \frac{P2 - P1'}{Ie2} - Reh \frac{Ie3}{Ie2}.$$

Der Strom, Ie3, durch die Hilfserde 18, Reh, entspricht auch dem vom Prüfstromgeber 11 abgegebenen Strom Ie3. Statt den Strom durch die Hilfserde zu messen, kann der Strom auch über die definierte Abgabe vom Prüfstromgeber 11 bestimmt werden.

Im Ausführungsbeispiel nach FIG 2 ist der Erdungswiderstand 17 des die Anlage versorgenden Netzes, Rev, in die Bestimmung des Erdungsableitwiderstandes 10, Rea, nicht einbezogen.

## Patentansprüche

1. Verfahren zur Ermittlung des Ableitwiderstandes, Rea, bei einem Installationsnetz mit Neutralleiter (7), Erdungssystem und Potentialausgleichsschiene (8), die über einen Erdungsleiter (9) bei einem Erdungsableitwiderstand, Rea, geerdet ist, **dadurch gekennzeichnet,** **daß** die Potentialausgleichsschiene (8) von einem Prüfstromgeber (11) beaufschlagt wird, daß der Erdungsleiter (9) der Potentialausgleichsschiene (8) durch einen Strommesser (13) überwacht wird und dieser als Zweitstrom, Ie2, erfaßt wird, wobei ein zweites Potential, P2, an der Potentialausgleichsschiene (8) erfaßt wird

   - und **daß** weiter entweder ein erstes Potential, P1, am Neutralleiter (7) erfaßt wird, wobei vom Neutralleiter (7) ein Erdungsleiter bei einem bekannten Erdungswiderstand (17) des die Anlage versorgendes Netzes , Rev, zur Erde geführt ist und daß der Erdungsableitwiderstand (10), Rea, am Erdungsleiter der Potentialausgleichsschiene ermittelt wird nach dem Algorythmus

   $$Rea = \frac{P2 - P1}{Ie2} - Rev;$$

   - oder daß weiter ein erstes Potential, P1', am erdabgewandten Ende einer Hilfserde (18), Reh, erfaßt wird sowie der Strom durch diese Hilfserde als Drittstrom, Ie3, und daß der Erdungsableitwiderstand (10), Reh, am Erdungsleiter (9) der Potentialausgleichsschiene (8) ermittelt wird nach dem Algorythmus

   $$Rea = \frac{P2 - P1'}{Ie2} - Reh\,\frac{Ie3}{Ie2}.$$

2. Verfahren nach Anspruch 1, **dadurch gekennzeichnet, daß** die Potentialausgleichsschiene (8) unmittelbar von einem Prüfstromgeber (11) beaufschlagt wird.

3. Verfahren nach Anspruch 1 oder 2, **dadurch gekennzeichnet,** **daß** der Prüfstromgeber (11) ein Oszillator ist, der bei Frequenzen höher als die Netzfrequenz betrieben wird, oder eine Gleichstromquelle.

4. Installationsnetz mit Neutralleiter (7), Erdungssystem und Potentialausgleichsschiene (8), die über einen Erdungsleiter (9) bei einem Erdungsableitwiderstand (10), Rea, geerdet ist, **dadurch gekennzeichnet,** **daß** an der Potentialausgleichsschiene (8) ein Prüfstromgeber (11),insbesondere ein Oszillator, angeschlossen ist und daß der Erdungsleiter (9) der Potentialausgleichsschiene (8) durch einen Strommesser (13) für einen Zweitstrom, Ie2, überwacht ist, wobei eine Potentialmeßeinrichtung für ein zweites Potential, P2, der Potentialausgleichsschiene (8) zugeordnet ist

   - und **daß** entweder eine Potentialmeßeinrichtung dem Neutralleiter (7) zur Erfassung eines ersten Potentials, P1, zugeordnet ist, wobei vom Neutralleiter (7) ein Erdungsleiter bei einem bekannten Erdungswiderstand (17) des die Anlage versorgenden Netzes, Rev, zur Erde geführt ist, und daß der Erdungsableitwiderstand (10), Rea, am Erdungsleiter (9) der Potentialausgleichsschiene (8) ermittelbar ist, gemäß dem Algorythmus

   $$Rea = \frac{P2 - P1}{Ie2} - Rev;$$

   - oder daß weiter eine Potentialmeßeinrichtung dem erdabgewandten Ende einer Hilfserde (18), Reh, zugeordnet ist zur Erfassung eines ersten Potentials, P1', daß eine Strommeßeinrichtung (13) der Hilfserde (18) zugeordnet ist zur Erfassung des Stromes als Drittstrom, Ie3, und daß der Erdungsableitwiderstand (10), Rea, am Erdungsleiter (9) der Potentialausgleichsschiene (8) ermittelbar ist gemäß dem Algorythmus

   $$Rea = \frac{P2 - P1'}{Ie2} - Reh\,\frac{Ie3}{Ie2}.$$

5. Installationsnetz nach Anspruch 4, **dadurch gekennzeichnet,** **daß** zumindest ein Teil der Erfassungen in einer Meß- und Steuereinheit (14) erfolgt.

6. Installationsnetz nach Anspruch 5, **dadurch gekennzeichnet,** **daß** die Meß- und Steuereinheit (14) an einem Melde- und Steuerbus angeschlossen ist.

## Claims

1. Method of determining the leakage resistance, Rea, in a distribution system with neutral conductor (7), earthing system and equipotential bonding strip (8) which is earthed via an earthing conductor (9) in the case of an earth leakage resistance, **characterised in that** a test current sensor (11) is applied to the equipotential bonding strip (8), that the earthing conductor (9) of the equipotential bonding strip (8) is monitored by an ammeter (13) and this is recorded as secondary current, Ie2, a second potential, P2, being recorded at the equipotential bonding strip (8)

- and that further either a first potential, P1, is recorded at the neutral conductor (7), an earthing conductor being conducted to earth by the neutral conductor (7) in the case of a known earthing resistance (17) of the power system, Rev, supplying the installation, and that the earthing leakage resistance (10), Rea, is determined at the earthing conductor of the equipotential bonding strip in accordance with the algorithm

$$Rea = \frac{P2 - P1}{Ie2} - Rev;$$

- or that further a first potential, P1', is recorded at the end of an auxiliary earth electrode (18), Reh, facing away from earth and the current is recorded by this auxiliary earth electrode as tertiary current, Ie3, and that the leakage resistance (10), Reh, is determined at the earthing conductor (9) of the equipotential bonding strip (8) in accordance with the algorithm

$$Rea = \frac{P2 - P1'}{Ie2} - Reh \frac{Ie3}{Ie2}.$$

2. Method in accordance with Claim 1, **characterised in that** a test current sensor (11) is applied directly to the equipotential bonding strip (8).

3. Method in accordance with Claim 1 or 2, **characterised in that** the test current sensor (11) is an oscillator which is operated at frequencies higher than the mains frequency, or a d.c. source.

4. Distribution system with neutral conductor (7), earthing system and equipotential bonding strip (8) which is earthed via an earthing conductor (9) in the case of an earth leakage resistance (10),
**characterised in that**
a test current sensor (11), in particular an oscillator, is connected to the equipotential bonding strip (8), and that the earthing conductor (9) of the equipotential bonding strip (8) is monitored by an ammeter (13) for a secondary current, Ie2, a potential measurement device for a second potential, P2, being associated with the equipotential bonding strip (8)

- and that either a potential measurement device is associated with the neutral conductor (7) to record a first potential, P1, an earthing conductor being conducted to earth by the neutral conductor (7) in the case of a known earthing resistance (17) of the power system, Rev, supplying the installation, and that the earthing leakage resistance (10), Rea, can be determined at the earthing conductor (9) of the equipotential bonding strip (8) in accordance with the algorithm

$$Rea = \frac{P2 - P1}{Ie2} - Rev;$$

- or that further a potential measurement device is associated with the end of an auxiliary earth electrode (18), Reh, facing away from earth to record a first potential, P1', that an ammeter (13) is associated with the auxiliary earth electrode (18) to record the current as tertiary current, Ie3, and that the leakage resistance (10), Reh, can be determined at the earthing conductor (9) of the equipotential bonding strip (8) in accordance with the algorithm

$$Rea = \frac{P2 - P1'}{Ie2} - Reh \frac{Ie3}{Ie2}.$$

5. Distribution system in accordance with Claim 4, **characterised in that** at least part of the determination takes place in a measurement and control unit (14).

6. Distribution system in accordance with Claim 5, **characterised in that** the measurement and control unit (14) is connected to a signalling and control bus.

## Revendications

1. Procédé de détermination de la résistance de terre Rea dans un réseau électrique avec conducteur neutre (7), système de mise à la terre et barre d'équipotentialité (8) qui est mise à la terre par l'intermédiaire d'un conducteur de mise à la terre (9) au niveau d'une résistance de terre Rea,
   **caractérisé par le fait que**
   la barre d'équipotentialité (8) est alimentée par un générateur de courant de test (11), le conducteur de mise à la terre (9) de la barre d'équipotentialité (8) est surveillé par un mesureur de courant (13) et ce courant est détecté comme deuxième courant le2, un deuxième potentiel P2 étant détecté à la barre d'équipotentialité (8), et

   - soit un premier potentiel P1 est détecté sur le conducteur neutre (7), un conducteur de mise à la terre étant envoyé à la terre depuis le conducteur neutre (7) au niveau d'une résistance de terre connue Rev (17) du réseau alimentant l'installation, et la résistance de terre Rea (10) au niveau du conducteur de mise à la terre de la barre d'équipotentialité est déterminée selon l'algorithme

$$Rea = \frac{P2 - P1}{Ie2} - Rev;$$

- soit un premier potentiel P1' est détecté à l'extrémité, éloignée de la terre, d'une terre auxiliaire Reh (18), le courant à travers cette terre auxiliaire est détecté comme troisième courant Ie3 et la résistance de terre Reh (10) au niveau du conducteur de mise à la terre (9) de la barre d'équipotentialité (8) est déterminée selon l'algorithme

$$Re\textit{a} = \frac{P2 - P1'}{Ie2} - Reh\,\frac{Ie3}{Ie2}.$$

2. Procédé selon la revendication 1,
   **caractérisé par le fait que** la barre d'équipotentialité (8) est alimentée directement par un générateur de courant de test (11).

3. Procédé selon la revendication 1 ou 2,
   **caractérisé par le fait que** le générateur de courant de test (11) est un oscillateur, qui fonctionne avec des fréquences supérieures à la fréquence de réseau, ou une source de courant continu.

4. Réseau électrique avec conducteur neutre (7), système de mise à la terre et barre d'équipotentialité (8) qui est mise à la terre par l'intermédiaire d'un conducteur de mise à la terre (9) au niveau d'une résistance de terre Rea (10),
   **caractérisé par le fait que**
   un générateur de courant de test (11), notamment un oscillateur, est raccordé à la barre d'équipotentialité (8), le conducteur de mise à la terre (9) de la barre d'équipotentialité (8) est surveillé par un mesureur de courant (13) pour un deuxième courant Ie2, un dispositif de mesure de potentiel pour un deuxième potentiel P2 étant associé à la barre d'équipotentialité (8), et

- soit un dispositif de mesure de potentiel est associé au conducteur neutre (7) pour la détection d'un premier potentiel P1, un conducteur de mise à la terre étant envoyé à la terre depuis le conducteur neutre (7) au niveau d'une résistance de terre connue Rev (17) du réseau alimentant l'installation, et la résistance de terre Rea (10) au niveau du conducteur de mise à la terre (9) de la barre d'équipotentialité (8) est déterminée selon l'algorithme

$$Rea = \frac{P2 - P1}{Ie2} - Rev;$$

- soit un dispositif de mesure de potentiel est associé à l'extrémité, éloignée de la terre, d'une terre auxiliaire Reh (18) pour la détection d'un premier potentiel P1', un dispositif de mesure de courant (13) est associé à la terre auxiliaire (18) pour la détection du courant comme troisième courant Ie3 et la résistance de terre Rea (10) au niveau du conducteur de mise à la terre (9) de la barre d'équipotentialité (8) peut être déterminée directement selon l'algorithme

$$Re\textit{a} = \frac{P2 - P1'}{Ie2} - Reh\,\frac{Ie3}{Ie2}.$$

5. Réseau électrique selon la revendication 4,
   **caractérisé par le fait qu'**au moins une partie des détections s'effectue dans une unité de mesure et de commande (14).

6. Réseau électrique selon la revendication 5,
   **caractérisé par le fait que** l'unité de mesure et de commande (14) est raccordée à un bus de signalisation et de commande.

FIG 1

EP 0 864 873 B1

FIG 2